# EUROPEAN PATENT APPLICATION

(11) **EP 3 618 584 A1**
(43) Date of publication of application: **04.03.2020**
(21) Application number: 18191087.8
(22) Date of filing: 28.08.2018
(51) Int. Cl.: H05K 1/18, H05K 1/14, H05K 3/46

(54) **ELECTRONIC DEVICE AND METHOD OF MANUFACTURING THE SAME**

(71) Applicant: Nederlandse Organisatie voor toegepast- natuurwetenschappelijk onderzoek TNO, 2595 DA 's-Gravenhage (NL)
(72) Inventor: DE SCHIPPER, Mathijs Rien, 2595 DA 's-Gravenhage (NL); GERMS, Wijnand Christiaan, 2595 DA 's-Gravenhage (NL); VAN DER WERFF, Jeichienus Johannes, 2595 DA 's-Gravenhage (NL); MAALDERINK, Herman Hendrikus, 2595 DA 's-Gravenhage (NL); BRUNNING, Fabien Bernard Jacques, 2595 DA 's-Gravenhage (NL); RIJFERS, Andries, 2595 DA 's-Gravenhage (NL)
(74) Representative: V.O.

(57) **Abstract**

An electronic device (1), is provided that comprises an electronic component (30) that is arranged on a component carrier (23) in a cavity (14) of a stack (10) of layers. One or more layers carry electrical conductors (15). The cavity (14) extends through the stack of layers from one of said layers (12n) to another one of said layers (12x). The component carrier (23) comprises electrically conductive tracks (24) from electric contacts (31) of the electronic component (30) to electric terminals (25) of the component carrier to a wall of the cavity to form an electrical connection with a respective one of said electrical conductors (15).

## Description

### BACKGROUND OF THE INVENTION

### Field of the invention

The present invention pertains to an electronic device.

The present invention further pertains to a method of manufacturing the same.

### Related Art

3D printing is an additive manufacturing technology wherein a carrier material is deposited in a layer by layer process to obtain a structured stack of layers. One or more components may be embedded in the structured stack. The usual process is to print the stack so as to form a cavity therein, to embed the component in the cavity, to print conductive materials on top of the component and to continue the layer deposition process.

EP 1 592 588 describes a method that uses a printing system including at least one printhead for printing material to create a printed product, and an object incorporation device that incorporates components into the product being printed whilst the at least one printhead prints the product. To that end the printing process may create the cavities into which such components may be inserted. The cited document observes that "Where electrically active devices are inserted, the devices are preferably inserted with the bond pads 616 facing upwards as this makes the forming of good quality electrical connections much easier. With upward facing bond pads, electrical connections may be formed in the next few layers to be printed. In contrast, bond pads on the bottom or sides of the object will rely on correct placement of the object and good contact."

Hence, it is a disadvantage of this known method that it imposes restrictions on the orientation with which the components are to be embedded

There is a need for an electronic device wherein a component is embedded in a structured stack of layers at an angle deviating from this imposed orientation. There is a further need for an improved process that allows for more freedom in the choice of the orientation of the components.

### SUMMARY OF THE INVENTION

In accordance with a first aspect of the present invention an electronic device is provided as claimed in claim 1.

In accordance with a second aspect of the present invention a method of manufacturing an electronic device is provided as claimed in claim 9.

The claimed electronic device comprises
- a stack of layers, wherein one or more of those layers carry electrical conductors,
- a cavity which extends through the stack of layers from one of said layers to another one of said layers,
- a component carrier being accommodated in the cavity, wherein the component carrier supports at least one electronic component and comprises electrically conductive tracks from electric contacts of the at least one electronic component to electric terminals extending from the component carrier to a wall of the cavity to form an electrical connection with a respective one of said electrical conductors.

The claimed method of manufacturing the electronic device, comprises the steps of:
- depositing a stack of layers, the deposited stack of layers having a surface, and a cavity, which is accessible through an opening in said surface, wherein one or more of said layers are provided with electrical conductors;
- inserting a component carrier supporting at least one electronic component in the cavity, wherein the component carrier comprises electrically conductive tracks from electric contacts of the at least one electronic component to electric terminals;
- electrically connecting the electric terminals, being provided in a direction towards a wall of the cavity, with a respective ones of said electrical conductors.

It is noted that in addition to the electronic component specifically referred to also further components may be arranged on the component carrier.

The electrical connection from the electric contacts of the component to corresponding contacts with respective electrical conductors at a surface of the one of said layers, via the electrically conductive tracks of the component carrier and its electric terminals, that extend in a direction towards a wall of the cavity, allows an independent orientation of the component with respect to the layer surface having the electrical conductors.

In an embodiment of the electronic device the component carrier is integral with an electric terminal carrier carrying the electric terminals and that extends through the wall to in between mutually subsequent layers. In an embodiment of this embodiment the component carrier and the electric terminal carrier are of a rigid material and are interconnected by a flexible interface.

Due to the fact that only the interface is flexible, the component carrier can be handled relatively easily in a manufacturing process. Alternatively, the component carrier and the electric terminal carrier may be provided as a flexible foil. This allows additional tolerances in the manufacturing process.

In an embodiment the electric terminals are resilient elements that are arranged in tensed state to the contact points of the electrical conductors.

In an embodiment the electric terminals are formed by an adhesive material. It is favorable if the adhesive has an anisotropic conductivity, its conductivity in lateral directions with respect to a surface at which it is applied being lower than a conductivity in a perpendicular direction with respect to said surface.

According to another option the electric contacts of the electronic component are adhered to said electrically conductive tracks with a cured metal paste.

In an embodiment of the electronic device the cavity has a wedge shape cross-section, tapering outward to the opening. This embodiment allows for a relatively easy placement of the component carrier with the component inside the cavity, while providing for a good fixation once the placement is completed.

In an application, of the electronic device the electronic component is a light emitting device, and the stack of layers is translucent. In this application, the component carrier may have arranged thereon for example in addition component(s) to control the light emitting device and/or sensor components, e.g. to sense an intensity of impinging light.

### BRIEF DESCRIPTION OF THE DRAWINGS

These and other aspects are described in more detail with reference to the drawing. Therein:
FIG. 1 shows a perspective view of an embodiment of the electronic device according to the first aspect.
FIG. 2 shows a cross-sectional view of that embodiment.
FIG. 3 shows according to the same cross-sectional view a portion of that embodiment in more detail.
FIG. 4 shows a top-view according to IV in FIG. 3.
FIG. 5A to 5C show different views of a component carrier provided with a component.
FIG. 6A-6E show subsequent steps in an embodiment of a method of manufacturing according to the second aspect of the invention.
FIG. 7A, 7B shows additional steps of in an embodiment of a method of manufacturing according to the second aspect of the invention.
FIG. 8A-8F show a first set of further embodiments.
FIG. 9A-9F show a second set of further embodiments.
FIG. 10A, 10B show a still further embodiment of the electronic device.
FIG. 11A, 11B, 11C show another embodiment of a method of manufacturing resulting in the intermediate product shown in FIG. 11C.
FIG. 12A, 12B show an additional embodiment of the electronic device..

### DETAILED DESCRIPTION OF EMBODIMENTS

Like reference symbols in the various drawings indicate like elements unless otherwise indicated.

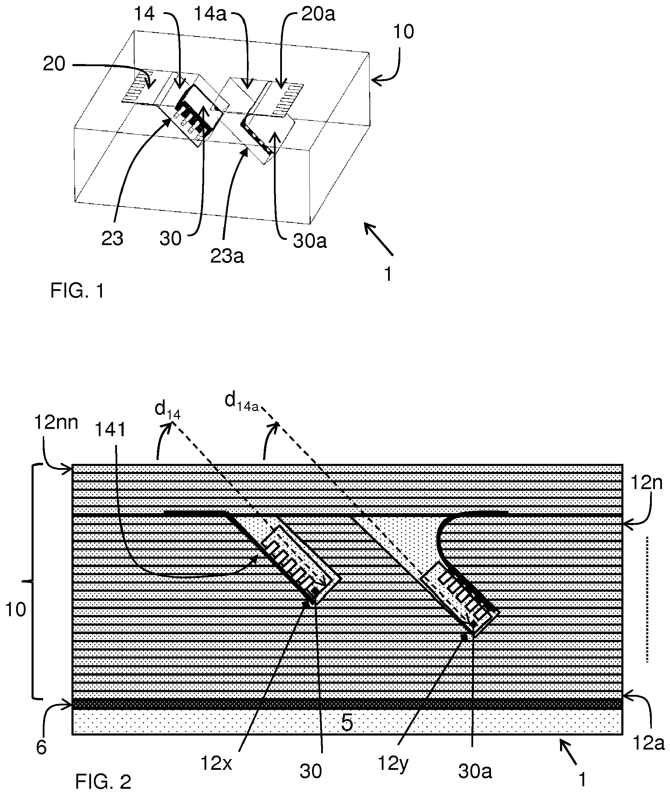

FIG. 1. shows an electronic device 1 that comprises a stack 10 of layers. The stack 10 has a cavity 14 wherein a component carrier 23, which is part of a carrier module 20 and provided with an electronic component 30 is arranged. The electronic product in this example comprises a further electronic component 30a which is arranged on a further component carrier 23a within a further cavity 14b in the stack 10.

FIG. 2 shows a cross-sectional view of the product of FIG. 1. As shown therein, the cavity 14 extends through the stack of layers from one of the layers, denoted as 12n to another one of said layers 12x in a direction d₁₄. The direction is d₁₄ is in between a direction aligned with a plane of the one 12n of the layers and a direction perpendicular to that plane. In the example shown the direction of the cavity 14 is at an angle of approximately 45 degrees. Alternatively another angle may be selected that deviates from one aligned with or perpendicular to the plane of 12n, for example in a range between 5 and 85 degrees or a range between 95 and 175 degrees. However alternatively the direction of the cavity may be even selected as perpendicular to the plane of 12n or close to perpendicular. In the embodiment shown, the further cavity 14a extends from the layer 12n to another 12y, at a different level than the layer 12x. The extension direction d₁₄ₐ of the further cavity 14a is approximately the same as that of the cavity 14, but that is not necessary. It is also not necessary that the cavities 14, 14a end in the same layer 12n, as is the case here. FIG. 2 shows that the stack 10 of layers 12 of the electronic device 1 comprises further layers until a top layer 12nn on the layer 12n. In such further layers still further cavities accommodating respective further component carriers with electronic components may be provided, but this is not necessary, also additional layers above layer 12n may be absent in other embodiments.

In the embodiment shown the stack 10 is provided on a substrate 5. The substrate 5 is optional and may serve during a manufacturing stage as a surface on which to deposit the layers 12a to 12nn. In the embodiment shown, a release layer 6 is provided between the substrate 5 and the stack 10, so that the substrate 5 (and the release layer 6) can be released from the stack 10 if desired.

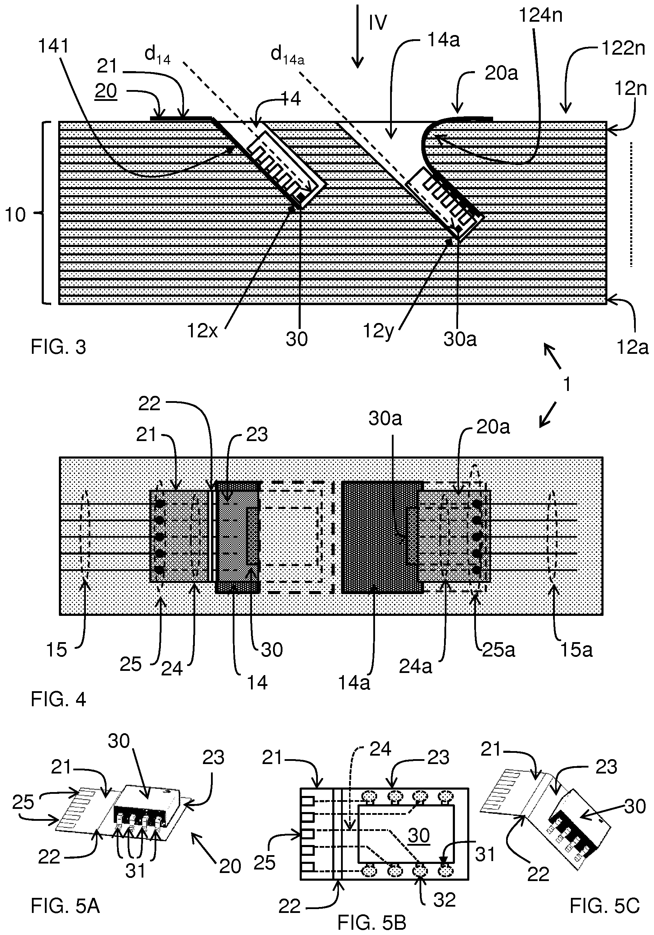

As shown in more detail in FIG. 3, 4 in the embodiment of FIG. 1, the component carrier 23 is integral with an electric terminal carrier 21 that carries the electric terminals. The component carrier 23 and the electric terminal carrier 21 form a carrier module 20. The electric terminal carrier 21 extends through the wall 141 to in between mutually subsequent layers, where the electric terminals are electrically connected with the electrical conductors carried by one of those mutually subsequent layers 12n. The component carrier 23 that supports the electronic component 30 is accommodated in the cavity 14.

More in particular, FIG. 3 depicts a portion of the stack 10, excluding the layers above layer 12n. FIG. 4 is a top-view according to IV in FIG. 3 of this portion. An exemplary carrier module 20 and the component 30 supported by its component carrier are shown in more detail in FIG. 5A, 5B and 5C.

FIG. 3,4 show that the component carrier 23 is accommodated in the cavity. The carrier module 20, which supports the electronic component 30 at its component carrier 23 within the cavity 14 comprises electrically conductive tracks 24 from electric contacts 31 of the electronic component to electric terminals 25 at the electric terminal carrier 21 that extends over layer 12n. The electric terminals 25 are electrically connected with respective electrical conductors 15 at a surface 122n of the layer 12n.

In this exemplary embodiment of the electronic device according the electronic component 30 is a light emitting device and the stack 10 of layers is translucent. Alternatively or in addition other electronic components may be provided for example on a same component carrier 23 or on another component carrier in another cavity.

In the embodiment shown, the carrier module 20 is a printed circuit board having the electric terminal carrier 21 as a first rigid portion 21, and the component carrier 23 as a second rigid portion and further a flexible portion 22 that forms the flexible interconnecting interface between the electric terminal carrier 21 and the component carrier 23. The flexible portion 22 provides for a blunt angle of about 135 degrees between the first rigid portion 21 and the second rigid portion 23. By way of example, the further component carrier 23a that carries the further electronic component 30a is a portion of a flexible foil. Further, in this example the flexible foil 20a is folded over a part of the surface 122n above the cavity and that portion forms a electric terminal carrier. To avoid an unduly high curvature in the flexible foil 20a, an edge portion 124n at that part of the surface 122n is curved, for example with a radius of curvature of a few mm.

FIG. 4 further shows the electrically conductive tracks 24a extending from electric contacts of the further electronic component 30a to further electric terminals 25a that are electrically connected with further electrical conductors 15a at the surface 122n of the layer 12n. As can be seen in FIG. 3, in this case, where the flexible foil 20a is folded over a part of the surface 122n above the cavity 14a the combination of the component carrier 23a with the component 30a and the electric terminal carrier formed by the folded portion only requires a modest surface area. In order to be able to reuse the surface area defined by the opening of the cavity, the cavity may be filled, for example with the same material as used for the layers of the stack.

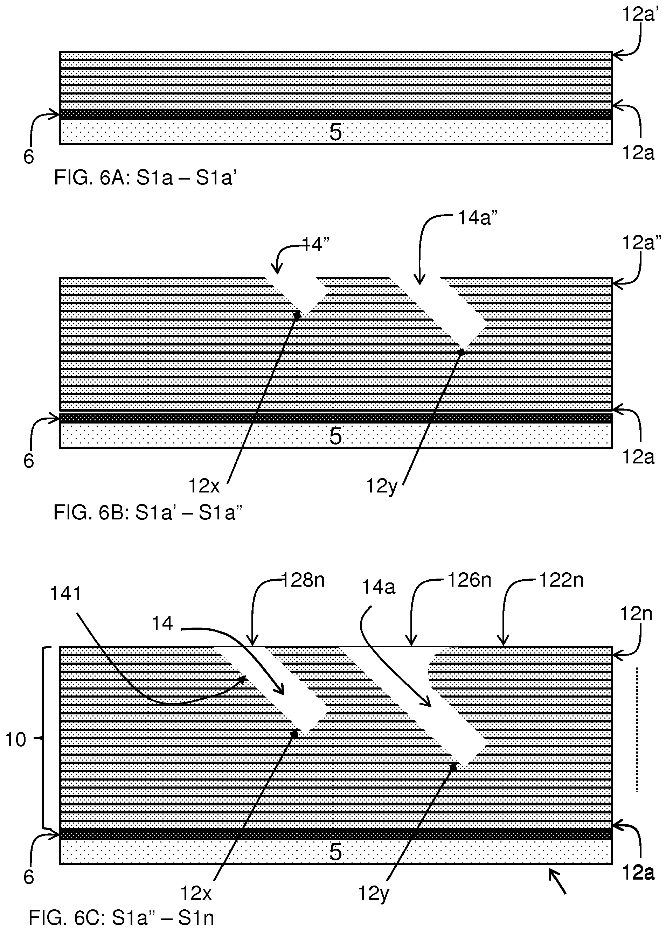

A method of manufacturing the electronic device is now illustrated with reference to FIG. 6A-6E. Therein FIG. 6A schematically show how a stack 10 of layers is deposited.

FIG. 6A shows a first intermediate product obtained after deposition of layers 12a to 12a' in steps S1a - S1a'. The layers 12a to 12a' are deposited on a substrate 5. A release layer 6 may be provided, so that the stack 10, optionally including the release layer 6 can be released from the substrate 5. Alternatively the substrate 5 may remain with the product.

Further layers including layer 12a" are deposited in subsequent steps S1a'-S1a" as shown in FIG. 6B. The material of the subsequent layers is deposited in a patterned manner, so that cavities 14" and 14a" start to form, respectively from layer 12x , 12y onwards.

As shown in FIG. 6C, the formation of the cavities 14, 14a is completed after deposition of layer 12n and the cavities are accessible through an opening 128n, 126n in the surface 122n of the layer 12n.

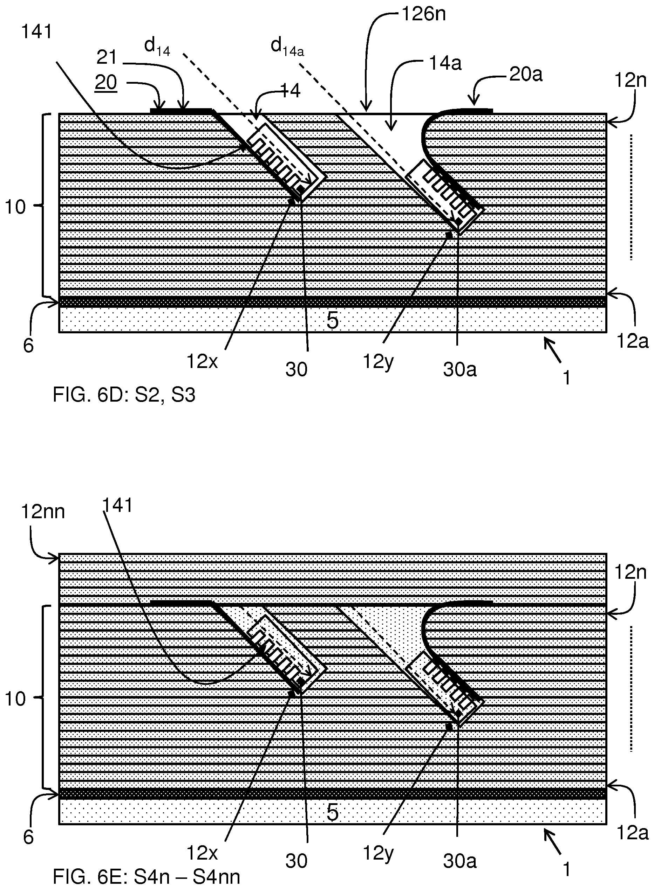

As shown in FIG. 6D, upon completion of the cavities 14, 14a, step S2 follows, wherein component carriers supporting electronic components 30, 30a and being part of carrier modules 20, 20a are inserted. In a step S3, as also schematically shown in FIG. 6D, electric terminals 25 (See FIG. 4) arranged at a terminal carrier 21 of carrier module 20, are electrically connected with respective electrical conductors 15 at the surface 12n of the stack of layers 10. A curable metal paste or an electrically conductive adhesive, for example an anisotropically conductive adhesive may be used for this purpose.

Similarly a further carrier module 20a is provided having a first end which forms an electric terminal carrier extending outside the cavity 14a and a second end inside the cavity 14a forming a component carrier for component 30a. The electric terminals 25a (See FIG. 4) are electrically connected with respective electrical conductors 15a at the surface 12n of the stack of layers 10

FIG. 6E shows optional further steps S4n - S4nn, wherein further layers up to 12nn are deposited. After deposition of the further layers the terminal carrier 21 of carrier module 20 provides for electric terminals that extend from the component carrier of that carrier module 20 to a wall 141 of the cavity 14 to form an electrical connection with the electrical conductors 15 arranged between layer 12n and the subsequent layer.

Similarly, the end portion of the flexible foil 20a is a further electric terminal carrier that provides for electric terminals 25a that extend from the component carrier to a wall 141 of the cavity to form an electrical connection with the electrical conductors 15a arranged between layer 12n and the subsequent layer.

As shown in the right portion of FIG. 6D, insertion of the component carrier of the carrier module 20a with its component 30a is facilitated as the cavity 14a has a wedge shaped cross-section that tapers outward to the opening 14a.

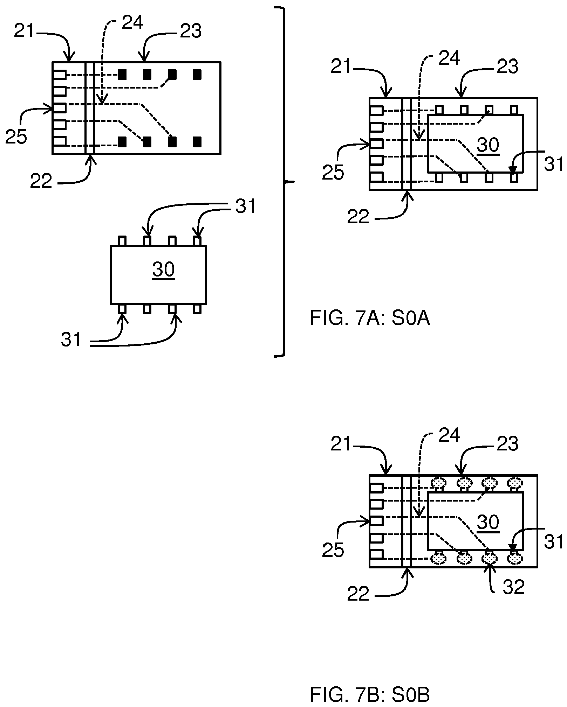

FIG. 7A shows a step SOA, wherein the electrical component 30 is assembled with the component carrier 23 of a carrier module 20 before the step S2 of inserting.

As schematically shown in FIG. 7B, the step of assembling may comprise the step of adhering SOB the electric contacts 31 of the electronic component 30 to the electrically conductive tracks 24 with an electrically conductive adhesive 32. The adhesive 32 may have an anisotropic conductivity. That is to say that its conductivity in lateral directions with respect to a surface at which it is applied is lower than a conductivity in a perpendicular direction with respect to said surface. Instead of using an adhesive, the electric contacts 31 of the electronic component 30 may be connected to the electrically conductive tracks 24 with a metal paste, e.g. a silver paste, which subsequently cured.

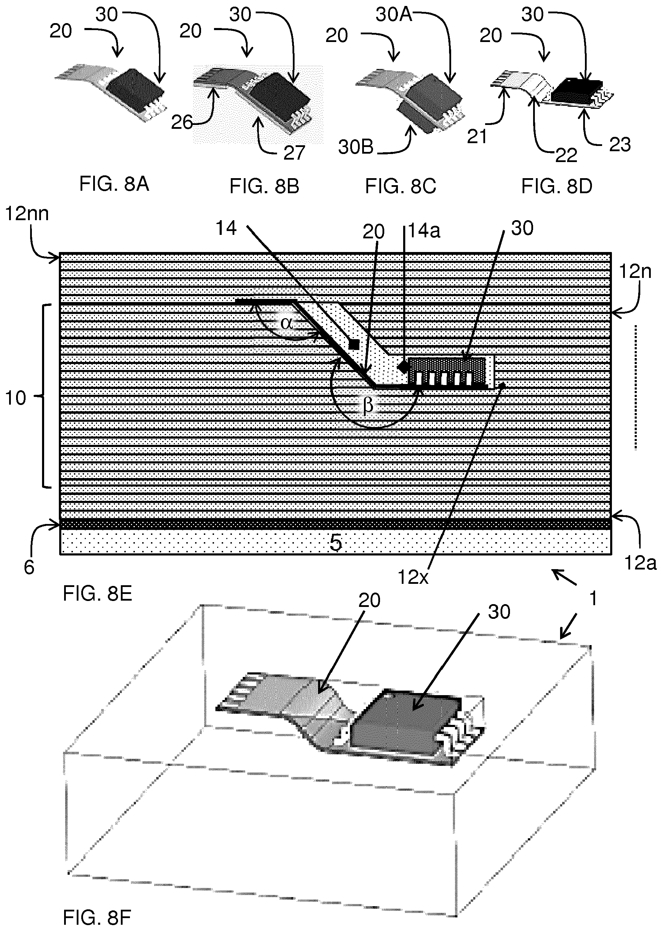

FIG. 8A to 8D show further examples of a carrier module 20 with one or more components 30, 30A, 30B, which may be used in embodiments of the claimed electronic device. In the example of FIG. 8A, the carrier module 20 is a single layer flexible PCB. As shown in FIG. 8D, the carrier module 20 has a first end portion 21 that serves as an electric terminal carrier, a second end portion 23 that serves as a component carrier and an intermediate portion 22, that allows the end portions to hinge with respect to one another.

In the example of FIG. 8B, end portions of the carrier module that define the terminal carrier and the component carrier are provided at their backside with a respective stiffening layer 26, 27. In the example of FIG. 8C, the end portion 23 to be inserted in the cavity is provided with an additional component 30B, opposite the component 30A. In the example of FIG. 8D, end portion 23 carrying the component 30 to be inserted in the cavity is in an orientation parallel to the end portion 21 having the electric contacts. As shown in FIG. 8E, this is achieved in that an angle α between the end portion 21 and an intermediate portion 22 is complimentary to an angle β (180-α) between the intermediary portion 22 and the end portion 23. Therewith the component 30 can be arranged aligned with a layer 12x at a lower level, than the level (layer 12n) where the electric contacts for that component 30 are provided. FIG. 8F shows a perspective view of this application.

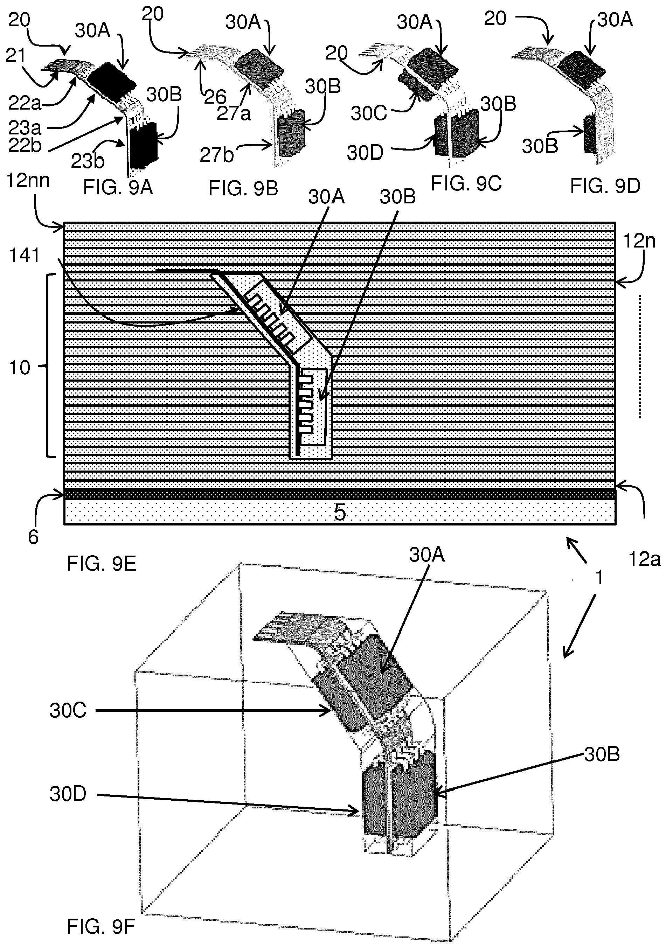

FIG. 9A to 9D show still further examples of a carrier module 20 with one or more components 30, 30A, 30B, suitable for use in embodiments of the claimed electronic device. In these examples the carrier module 20 has a plurality of component carriers 23a, 23b. Component carrier 23a, carrying component 30A, is coupled via flexible portion 22a with the terminal carrier 21 carrying the electric terminals. Component carrier 23b, carrying component 30B, is coupled via flexible portion 22b with component carrier 23a. As illustrated in FIG. 9E, the components 30A, 30B can therewith be arranged in a single cavity at mutually different angles. This is shown for example in FIG. 9E in a cross-section for example 9A, and in FIG. 9F in a perspective view for example 9C. It is further noted that in the example of FIG. 9B, the terminal carrier 21 and the component carriers 23a, 23b are provided at their backside with a respective stiffening layer 26, 27a, 27b. In the example of FIG. 9C, the component carriers 23a, 23b each are provided at their backside with a proper additional component 30C, 30D. In the example of FIG. 9D, component carrier 23a carries a first component 30A at its front side and component carrier 23b carries a second component 30B at its back side.

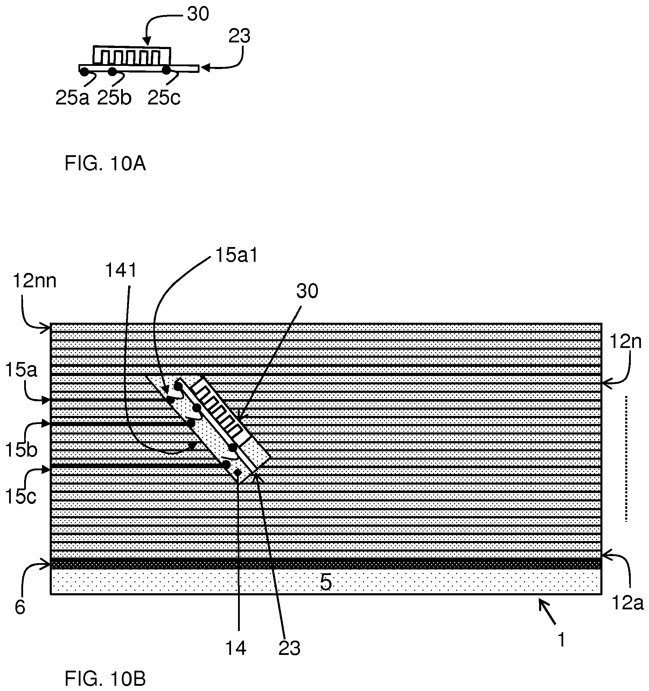

FIG. 10B shows another embodiment of the electronic device 1. Therein FIG. 10A shows the component carrier 23 provided with the component 30 in more detail. In the embodiment shown, the electric terminals 25a, 25b, 25c are resilient elements that are arranged in a tensed state to the contact points, e.g. 15a1 of the electrical conductors 15a, 15b, 15c. The contact points, such as 15a1 may be formed by depositing an electrically conductive material on an end of the corresponding electrical conductor, e.g. 15 at the boundary where a layer carrying that electrical conductor faces the wall 141 of the cavity 14. The electrically conductive material is for example an adhesive or solder. In a manufacturing process, the component carrier 23 can be inserted into the cavity 14 and when insertion is completed, the resilient elements 25a, 25b, 25c are arranged in a tensed state to the contact points at the wall 141, so that they form an electrical connection therewith.

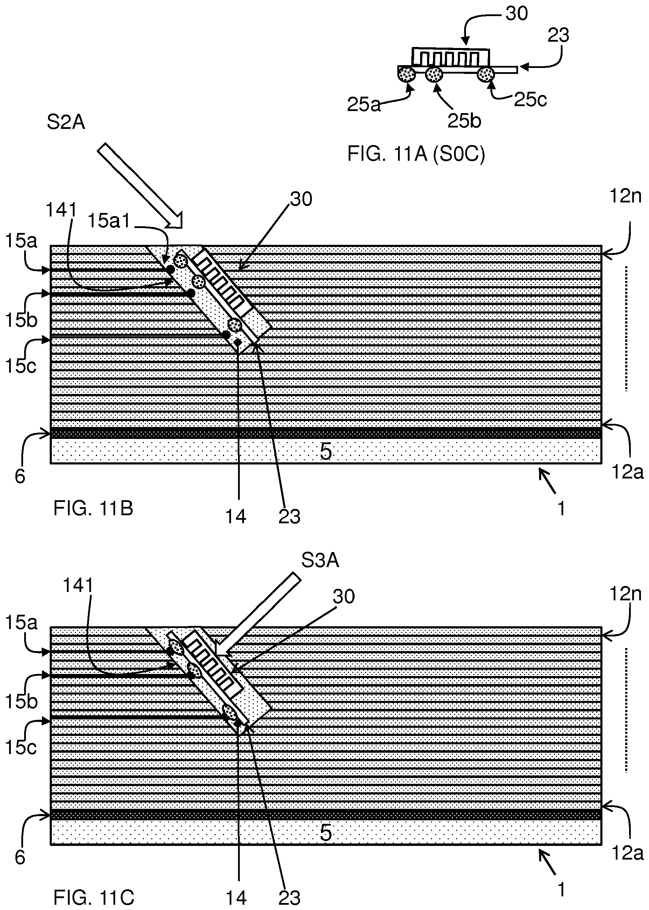

FIG. 11A, 11B and 11C show an alternative method of manufacturing an electronic device 1 according to the invention. As shown in FIG. 11A, therein the electric terminals 25a, 25b, 25c are provided (S0C) as adhesive electric contacts.

As further shown in FIG. 11B, the step of inserting (S2A) comprises keeping the adhesive electric contacts 25a, 25b, 25c away from the wall 141 of the cavity 14 until the adhesive electric contacts 25a, 25b, 25c face respective contacts, e.g. 15a1 of the electrical conductors 15a, 15b, 15c exposed at the wall. Subsequently an electric connection is provided as shown in FIG. 11C by moving (S3A) the component carrier 23 with the adhesive electric contacts 25a, 25b, 25c towards the wall in a direction aligned with the surface normal of the wall 141. The adhesive may for example be cured by UV-radiation, or as result of the exerted pressure. Alternatively the adhesive may be provided as a self-curing two-component material.

In alternative embodiment the adhesive electric contacts have an anisotropic conductivity, such that its conductivity in the lateral directions with respect to the surface of the wall is lower than a conductivity in a perpendicular direction with respect to the wall. In that case it is not necessary to keep the adhesive electric contacts 25a, 25b, 25c away from the wall 141 during insertion. Upon completion of the insertion, the adhesive electric contacts 25a, 25b, 25c already form an electrical connection with the electrical conductors 15a, 15b, 15c. The adhesive may for example be cured by UV-radiation, or as result of the exerted pressure. Alternatively the adhesive may be provided as a self-curing two-component material.

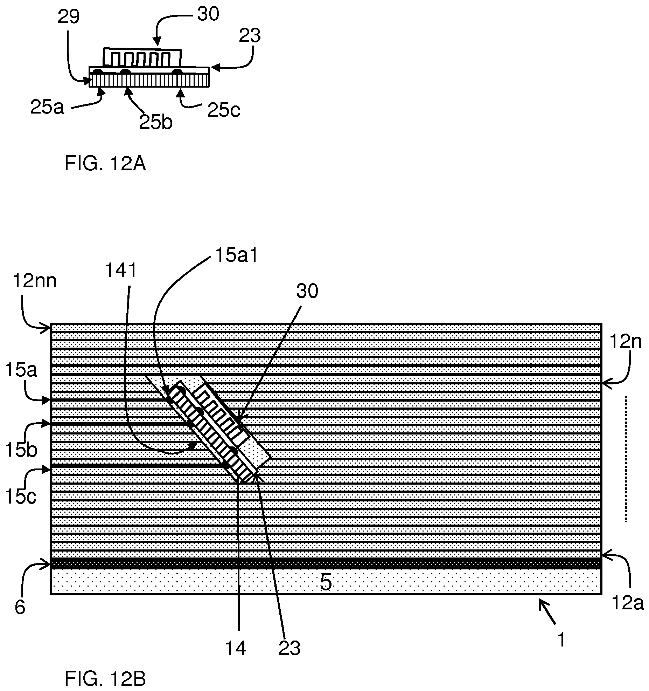

A still further embodiment is disclosed with reference to FIG. 12A, 12B. In the embodiment shown therein the electric terminals 25a, 25b, 25c are formed by an elastic interlayer 29 of an anisotropically electrically conductive material. The material is anisotropically electrically conductive in the sense that its conductivity in the lateral directions with respect to the surface of the wall 141 is lower than a conductivity in a perpendicular direction with respect to the wall.

It will be appreciated by the person skilled in the art that the carrier may be provided with a larger number of component carrier portions that are coupled between flexible intermediary portions.

In the appended claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. An electronic device (1), comprising:
- a stack (10) of layers (12a,...,12n), one or more layers carrying electrical conductors (15),
- a cavity (14, 14a) which extends through the stack of layers from one of said layers (12n) to another one of said layers (12x,12y),
- a component carrier (23, 23a) being accommodated in the cavity, wherein the component carrier supports at least one electronic component (30, 30a) and comprises electrically conductive tracks (24) from electric contacts (31) of the at least one electronic component to electric terminals (25) extending from the component carrier to a wall of the cavity to form an electrical connection with a respective one of said electrical conductors (15).

2. The electronic device according to claim 1, wherein the component carrier (23) is integral with an electric terminal carrier (21) carrying the electric terminals (25, 25a, 25b, 25c), and that extends through the wall between mutually subsequent layers.

3. The electronic device according to claim 2, wherein the electric terminal carrier (21) and the component carrier (23) are of a rigid material and are interconnected by a flexible interface (22).

4. The electronic device according to claim 2, wherein the electric terminal carrier (21) and the component carrier (23) are formed as portions of flexible foil (20a).

5. The electronic device according to claim 1, wherein the electric terminals (25a, 25b, 25c) are resilient elements that are arranged in tensed state to the contact points of the electrical conductors (15a, 15b, 15c).

6. The electronic device according to claim 1 wherein the electric terminals (25) are formed by an adhesive material.

7. The electronic device according to claim 6, wherein the adhesive material has an anisotropic conductivity, its conductivity in lateral directions with respect to a surface at which it is applied being lower than a conductivity in a perpendicular direction with respect to said surface.

8. The electronic device according to claim 6, wherein the electric contacts of the electronic component (30) are adhered to said electrically conductive tracks with a cured metal paste.

9. The electronic device according to one of the previous claims, wherein the cavity has a wedge shape cross-section, tapering outward to the opening.

10. The electronic device according to one of the previous claims, wherein the at least one electronic component (30) is a light emitting device, and wherein the stack of layers is translucent.

11. A method of manufacturing an electronic device, comprising the steps of:
- depositing (S1a - S1n) a stack of layers, the deposited stack of layers having a surface, and a cavity, which is accessible through an opening in said surface, wherein one or more of said layers are provided with electrical conductors (15, 15a, 15b, 15c);
- inserting (S2) a component carrier supporting at least one electronic component in the cavity, wherein the component carrier comprises electrically conductive tracks from electric contacts of the at least one electronic component to electric terminals (25, 25a, 25b, 25c);,
- electrically connecting (S3) the electric terminals, being provided in a direction towards a wall of the cavity, with a respective ones of said electrical conductors.

12. The method according to claim 11, further comprising the step of assembling (S0A) the electrical component with the component carrier before the step of inserting.

13. The method according to claim 12, wherein the step of assembling comprises providing (S0C) the electric terminals (25a, 25b, 25c) as adhesive electric contacts.

14. The method according to claim 13, wherein the step of inserting (S2A) comprises keeping the adhesive electric contacts (25a, 25b, 25c) away from the wall of said cavity until the adhesive electric contacts (25a, 25b, 25c) face respective contacts of the electrical conductors exposed at said wall and wherein the step of electrically connecting (S3A) comprises moving the component carrier (23) with the adhesive electric contacts (25a, 25b, 25c) towards the wall in a direction aligned with the surface normal of the wall.

15. The method according to claim 13, wherein the adhesive electric contacts .have an anisotropic conductivity, its conductivity in lateral directions with respect to a surface of the wall being lower than a conductivity in a perpendicular direction with respect to said wall.
